# EUROPEAN PATENT SPECIFICATION

(11) **EP 3 872 257 B1**
(45) Date of publication and mention of the grant of the patent: **28.02.2024**
(21) Application number: 19818248.7
(22) Date of filing: 23.10.2019
(51) Int. Cl.: D21H 11/18, B32B 5/26, D21H 17/63, D21H 17/67, D21H 27/32, D21H 27/38

(54) **DUAL FLEXIBLE CELLULOSE-BASED MATRIX FOR ELECTRONICS AND MICROFLUIDICS INTEGRATION**
MATRIZ DUAL FLEXÍVEL DE BASE CELULÓSICA PARA INTEGRAÇÃO DE ELECTRÓNICA E MICROFLUÍDICA
MATRICE DOUBLE SOUPLE À BASE CELLULOSIQUE POUR INTÉGRATION D'ÉLECTRONIQUE ET DE MICROFLUIDIQUE

(30) Priority: 24.10.2018 PT 2018115111
(43) Date of publication of application: 01.09.2021
(73) Proprietor: RAIZ - Instituto de Investigação da Floresta e Papel, 3800-783 Eixo (PT); The Navigator Company, S.A., 2910-738 Setúbal (PT); Universidade Nova de Lisboa, 1099-085 Lisboa (PT)
(72) Inventor: MENDES DE SOUSA, Antonio Paulo, 3800-783 Eixo (PT); CORREIA FORTUNATO, Elvira Maria, 2829-516 Caparica (PT); DA SILVA PEDROSA, Jorge Filipe, 3800-783 Eixo (PT); NUNES PEREIRA, Luís Miguel, 2829-516 Caparica (PT); DE OLIVEIRA RODRIGUES PINTO, Paula Cristina, 3800-783 Eixo (PT); ALVES RAMOS RODRIGUES, Ricardo Jorge, 3800-783 Eixo (PT); FERRÃO PAIVA MARTINS, Rodrigo, 2829-516 Caparica (PT)
(86) International application number: PCT/IB2019/059085
(87) International publication number: WO 2020/084534

(56) References cited:
- EP-A1- 1 936 032
- WO-A1-2018/002815
- US-A1- 2012 080 156
- DEVI D. LIANA ET AL: "Recent Advances in Paper-Based Sensors", SENSORS, vol. 12, no. 12, 24 August 2012 (2012-08-24), pages 11505-11526, XP055236777, DOI: 10.3390/s120911505

## Description

### FIELD OF THE INVENTION

The present invention relates to the field of double layered and double structure cellulosic matrices for simultaneous incorporation of microfluidics and electronics components, for sensor production and associated electronics, with applications in the medical, pharmaceutical, food, packaging, distribution, environmental and safety, agricultural, environmental and veterinary areas, among others.

### BACKGROUND OF THE INVENTION

Nowadays cellulosic products can evolve to specialized products to meet the demands of consumers, both from a technological and environmental point of view. Providing cellulose-based products with the ability of users interaction, through features that enable their intelligent specialization, leads to the development of a set of new high added value products^{[1]}.

Cellulose thus emerges as a flexible, lightweight, resilient, low cost, biodegradable and recyclable polymeric material, ideal for the development of simple, relatively low cost, fast response, small sized and mobile detection platforms, allowing the decrease of the sample volume required for detection. Possible application markets are found in the pharmaceutical, medical, food, environmental and safety industries, among others.

Microfluidics and printed electronics are two techniques that enable the development of intelligent detection platforms based on cellulosic matrices.

Printed electronics applications are currently achieved through well-defined production techniques such as flexography, screen printing, rotary screen printing, deep coating, inkjet and offset printing^{[2]}, or even laser induction^{[3]} on substrates ranging from fabrics, paper, glass and metal to plastics^{[4]}.

Different components can be printed to form intelligent integrated systems, from batteries, memory systems and active systems (transistors, diodes, logic circuits, display elements) or passive (resistors, capacitors and conductors)^{[5]}.

Inks used in printed electronics applications, called functional inks, are electrically active materials with conductive, semiconductor, luminescent, electrochemical or electrophoretic properties, and which may be constitutionally organic or inorganic. The type of used inks depends on the final application and on the printing and sintering/decomposition technique applied^{[5]}.

Examples of semiconductor organic inks used in printed electronics include, for example, those consisting of the conducting polymers poly (3,4-ethylenedioxythiophene) / poly (styrene sulfonate) (PEDOT/PSS) and polyaniline (PAni) .

Inorganic nanomaterials are also applied in the production of printed electronics, particularly through inks composed of gold (Au), silver (Ag), palladium (Pd), copper (Cu), tin (Sn) and nickel (Ni). Transparent conductive nanoinks consisting of indium tin oxide (ITO), zinc aluminum oxide (AZO) and zinc gallium oxide (GZO) are also found. Carbon based inks are also used, namely made up of graphite or graphene particles^{[6]}.

In addition to printing techniques, the developed cellulosic substrates will also serve as a basis for supporting the production of other devices using physical film growth techniques, such as cathode sputtering or atomic layer deposition, among others.

Microfluidics refers to the handling and processing of fluid volumes in the order of micro or nanoliters. It uses small sized systems and devices where channels with millimeter geometries are implemented through which fluids are carried to target zones, where chemical reactions and / or reading occur. Paper-based microfluidic analytical structures were first developed in 2007, and consist of hydrophilic and / or hydrophobic microchannel networks associated with analytical devices^{[7]}.

Different techniques are currently used for the production of paper microfluidic devices, namely photolithography, polydimethylsiloxane deposition (PDMS), jet printing, plasma treatment, paper cutting and wax printing^{[8]}.

The cellulosic matrix to be used in these applications depends on the manufacturing processes and on the area of application. The Whatman brand filter paper is the most commonly used in microfluidic applications, with well characterized porosity, flow velocity and particle retention parameters^{[9]}. Evans et al.^{[10]} additionally describes the use of a Whatman paper which is modified by immersing it in a suspension containing modified silica nanoparticles, which fit into the cellulose structure and support an improvement of intensity and uniformity of the emitted color by the detection device applied to the Whatman paper.

Nitrocellulose membranes have favorable characteristics for these applications, such as smoothness and a reproducible liquid flow through the paper. The attractiveness of nitrocellulose relates to its ability to irreversibly and hydrophobically bind to proteins by absorption. However, it has been reported that the speed of waxes in nitrocellulose is lower than when compared to the speed observed on filter paper^{[11]}.

Coated papers integrating, for example, inorganic fillers, may also be used for electronic circuit printing. According to Arena et al.^{[12]}, the non-degradability and relative smoothness of coated papers allows their use as substrates for the production of sensors using, for example, carbon nanotubes as electrodes.

In addition to the commercial Whatman filter paper, the Felix Schoeller Group makes commercially available a high smoothness paper specially developed for printed electronics, the P E:SMART paper type 3 (https://felix-schoeller.com/fileadmin/content/documents/downloads/pe sm art Type3.pdf [accessed on the 18-Jun-2019]). This paper has, at least, two resin-based coatings.

Paper detection devices can be used in many different applications. In the area of medical diagnostics, devices called Point-of-Care allow the detection of different diagnostic analytes such as glucose, uric acid, proteins, nitrates, ketones, cholesterol and nucleic acids^{[13]}. Ge et al.^{[14]} have also demonstrated how paper-based microfluidic devices, and through the paper folding technique, can be used to detect cancer biomarkers.

Food quality control is another area of application of these devices, from production to packaging. Paper sensors can be applied in the production of smart packaging capable of monitoring food quality (avoiding waste by setting shelf life by statistical methods). Examples further include the use of these paper-based detection devices for the detection of ethanol and pesticides in foods^{[15, 16]}.

These devices also have application in the areas of environmental monitoring, namely in the detection of heavy metals and other pollutants. Detection of gold and iron in industrial waste for recovery^{[17]}, and the detection of toxins in drinking water^{[18]}, are some examples of the application of paper sensors in environmental control.

The document WO2018002815 relates to laminates of MFC films and paper substrate for diposable electronics.

The document PT103999B^{[19]} describes a fiber-based cellulosic material as a physical carrier and storage medium or inductor of electrical charges in transistors, using active or organic semiconductor oxides. The invention aims at obtaining field effect electronic devices with memory effect.

The document PT103998^{[20]}, and its patent family (Russia, 2495516, Australia, 2009239685, Japan, 5734177, México, MX/a/2010/010225, South Korea, 10-1553089) refers to the procedure for using natural, synthetic cellulosic material, or a mixture of both, simultaneously as physical and dielectric support for the design of field effect devices and optoelectronic devices.

The document US8773747B2^{[21]} describes an electrochromic device consisting of electrode layers and of a cellulose-based material impregnated with a solution/dispersion containing electrochromic, electrolytic and counter electrode agents. The device is presented as simpler, faster and more cost-effective to construct, reducing the number of depositions required to achieve the same electrochromic function.

The document KR20100116433^{[22]} describes a flexible cellulosic paper transistor made up of nanotubes and applied to living bodies such as humans and animals.

The document WO2013181656A1^{[23]} describes a microfluidic device on a modified cellulosic substrate as to increase its hydrophobicity, by reacting cellulosic fibers with hydrophobic compounds, for example, by silanization and acylation reactions.

The article of Jenkis et al.^{[24]}, shows the printing of microfluidic lines and silver electrodes on nitrocellulose membranes.

The document WO2017040947A1^{[25]} describes a device including a substrate including a cellulose matrix providing an interconnected porous structure, a hydrophobic barrier arranged across the substrate thickness, to define at least one porous channel in the cellulose matrix volume, and an electrically conductive material. The electrically conductive material is disposed within the porous channel volume to coat at least a portion of the cellulose matrix.

In short, today's paper-based detection devices require the incorporation of microfluidic and electronic functionalities exploited on specific and distinct support media.

It is therefore necessary the development of an integrated cellulose-based detection system made up of a single material, allowing for a reduction in the costs of its production, as it may take place in a single industrial unit from the same raw material and without substantial changes to a common pulp and paper production process. It is also necessary that the developed solution does not require the incorporation of additives and coatings of fossil origin for their proper functioning. The use of these additives will make difficult the recyclability and/or biodegradability of cellulose-based detection systems.

Thus, in the state of the art, there is no reference to the existence or to the development of a technological solution based on a single, layered, flexible cellulosic matrix, which simultaneously allows the functional application of microfluidics and electronic circuits in order to obtain a sensor and its integrated electronics, of renewable origin, biodegradable, possible, for example, to be incinerated, and with recyclability rates similar to those of printing and writing paper, and which allows costs savings in the production of detection devices.

Such a problem is solved by the single, flexible, cellulose-based, double layered and double structure matrix, of different degree of compactness, for electronics, electrochemical and microfluidic integration disclosed herein. The new and disruptive concept presented in this invention also provides pulp and paper companies with the possibility of diversifying the products they make available to consumers, evolving the cellulosic pulp from a commodity (pulp for printing and writing paper) to a product with high degree of expertise, through an economically advantageous solution and with exceptional technical features, capable of meeting the quality standards required by the respective regulatory authorities.

### References

[1] Pedro Barquinha, Rodrigo Martins, Luis Pereira, Elvira Fortunato, Transparent Semiconductors: From Materials to Devices. West Sussex: Wiley & Sons (March 2012), ISBN 9780470683736.
[2] José Tiago Carvalho, Viorel Dubceac, Paul Grey, Inês Cunha, Elvira Fortunato, Rodrigo Martins, Andre Clausner, Ehrenfried Zschech, Luis Pereira, Fully Printed Zinc Oxide Electrolyte-Gated Transistors on Paper, Nanomaterials, 2019, 9(2), 169.
[3] Ruquan Ye, Dustin K. James, James M. Tour, Laser-Induced Graphene: From Discovery to Translation, Advance Materials, 2019, 31, 1803621.
[4] Joanna Izdebska, Sabu Thomas, Printing on Polymers: Fundamentals and Applications, 1st Edition, Plastics Design Library, Editor: William Andrew, 2015.
[5] Diana Gregor-Svetec, Chapter 8 - Intelligent Packaging, Nanomaterials for Food Packaging Materials, Processing Technologies, and Safety Issues Micro and Nano Technologies, Editor: Elsevier, 2018.
[6] Wei Wu, Inorganic nanomaterials for printed electronics: a review, Nanoscale, 2017, 9(22), 7342.
[7] Yanyan Xia, Jin Si, Zhiyang Li, Fabrication techniques for microfluidic paper-based analytical devices and their applications for biological testing: A review, Biosensors and Bioelectronics, 2016, 77, 774.
[8] Temsiri Songjaroen, Wijitar Dungchai, Orawon Chailapakul, Wanida Laiwattanapaisal, Novel, simple and low-cost alternative method for fabrication of paper-based microfluidics by wax dipping, Talanta, 2011, 85 (5), 2587.
[9] Maowei Dou, Sharma Timilsina Sanjay, Merwan Benhabib, Feng Xu, Xiu Jun Li, Low-cost bioanalysis on paper-based and its hybrid microfluidic platforms, Talanta, 2015, 145, 43.
[10] Elizabeth Evans, Ellen Flavia Moreira Gabriel, Tomas E. Benavidez,Wendell Karlos Tomazelli Coltrob, Carlos D. Garcia, Modification of microfluidic paper-based devices with silica nanoparticles, Analyst, 2014, 139(21), 5560.
[11] Yao Lu, Weiwei Shi, Jianhua Qin, Bingcheng Lin, Fabrication and Characterization of Paper-Based Microfluidics Prepared in Nitrocellulose Membrane By Wax Printing, Analytical Chemistry, 2009, 82(1),329.
[12] A Arena, Nicola Donato, Giuseppe Saitta, Giovanni Neri, Flexible ethanol sensors on glossy paper substrates operating at room temperature, Sensors and Actuators B Chemical, 2010, 145(1), 488.
[13] Devi Liana, Burkhard Raguse, J. Justin Gooding, Edith Chow, Recent Advances in Paper-Based Sensors, Sensors (Basel), 2012, 12(9), 11505.
[14] Lei Ge, Shoumei Wang, Xianrang Song, Shenguang Gea, Jinghua Yu, 3D origami-based multifunction-integrated immunodevice: low-cost and multiplexed sandwich chemiluminescence immunoassay on microfluidic paper-based analytical device, Lab Chip., 2012, 12(17), 3150.
[15] Zhihong Nie, Frédérique Deiss, Xinyu Liu, Ozge Akbulut, George M. Whitesides, Integration of paper-based microfluidic devices with commercial electrochemical readers, Lab Chip., 2010, 10(22), 3163.
[16] S. M. Zakir Hossain, Roger E. Luckham, Meghan J. McFadden John D. Brennan, Reagentless bidirectional lateral flow bioactive paper sensors for detection of pesticides in beverage and food samples, Analytical Chemistry, 2009, 81( 21), 9055.
[17] Amara Apilux, Wijitar Dungchai, Weena Siangproh,Narong Praphairaksit, Charles S. Henry, Orawon Chailapakul, Lab-on-paper with dual electrochemical/colorimetric detection for simultaneous determination of gold and iron, Analytical Chemistry, 2010, 82(5), 1727.
[18] Libing Wang, Wei Chen, Dinghua Xu, Bong Sup Shim, Yingyue Zhu, Fengxia Sun, Liqiang Liu, Chifang Peng, Zhengyu Jin, Chuanlai Xu, Nicholas A. Kotov, Simple, rapid, sensitive, and versatile SWNT-paper sensor for environmental toxin detection competitive with ELISA, Nano Letters, 2009, 9(12), 4147.
[19] PT103999B - Process creation and use of paper based on natural pulp fibers, synthetic fibers or mixtures thereof as a physical support medium and store electrical charges in field-effect transistors with memory self-sustaining without using oxides.
[20] PT103998B - Procedure for the use of natural cellulosic material, synthetic material or mixed natural and synthetic material, simultaneously as physical and dielectric support in self-sustainable field effect electronic and optoelectronic devices.
[21] US8773747B2 - Electrochromic device and method for producing same.
[22] KR20100116433 - Flexible cellulose paper transistor with covalently bonded nanotubes
[23] WO2013181656A1 - Microfluidic devices formed from hydrophobic paper
[24] Gareth Jenkins, Yang Wang, Ye Lei Xie, Qiong Wu, Wei Huang, Linghai Wang, Xin Yang, Printed electronics integrated with paper-based microfluidics: new methodologies for next-generation health care, Microfluidics and Nanofluidics, Microfluid Nanofluid, 2015,19(2), 251.
[25] WO2017040947A1 - Co-fabrication of paper electronics and microfluidics.
[26] L.J. van der Pauw, A method of measuring specific resistivity and hall effect of discs of arbitrary shape, Semiconductor Devices: Pioneering Papers, 1991, 174.
[27] Tom J. Zajdel, Moshe Baruch, Gábor Méhes, Eleni Stavrinidou, Magnus Berggren, Michel M. Maharbiz, Daniel T. Simon, Caroline M. Ajo-Franklin, PEDOT:PSS-based Multilayer Bacterial-Composite Films for Bioelectronics, Scientific Reports, 2018, 8, 1529.

### SUMMARY OF THE INVENTION

The invention disclosed herein consists of a flexible, cellulose-based, double layered and double structure, biodegradable, of renewable origin, lightweight and miniaturized matrix, capable of simultaneously integrating microfluidic functions as well as electronic and electrochemical components. The process of producing the cellulosic matrix disclosed herein is also described in this invention.

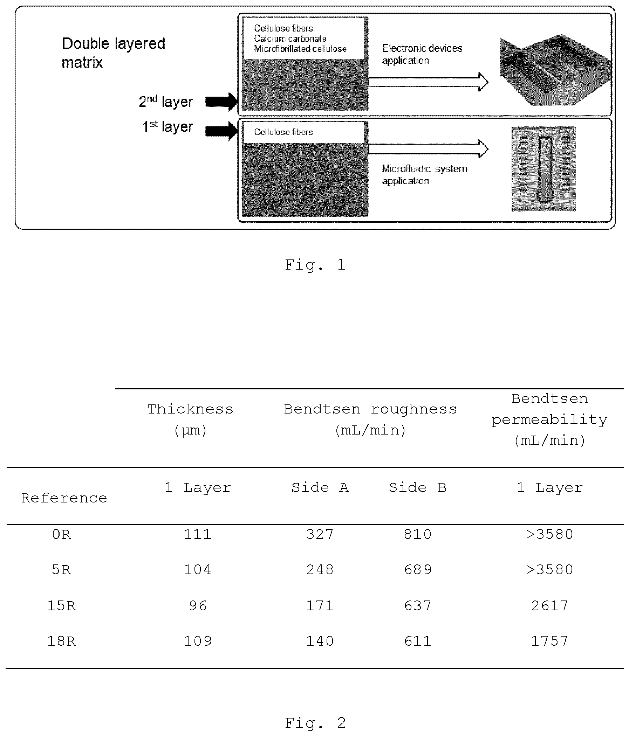

One of the layers produced from processed cellulosic fibers has the appropriate porosity and hydrophilic affinity level for fluid flow, ensuring microfluidic functionality. A second layer, also comprised of processed cellulosic fibers, includes micro- and/or nanoscale-produced cellulosic materials, i.e. cellulose micro and/or nanofibrils and at least one inorganic pigment. This layer must have the proper level of compaction and surface smoothness to ensure printing and integration of devices and electronic and electrochemical circuits (Figure 1).

The layer of the double layered cellulosic matrix for incorporation of microfluidic systems (first layer) has Bendtsen permeability values between 1500 and 3000 mL/min, more preferably between 2600 and 2700 mL/min.

The layer of the double layered cellulosic matrix for incorporation of microfluidic systems (first layer) is constituted by cellulosic fibers.

The layer of the double layered cellulosic matrix for electronic circuit printing (second layer) has a Bendtsen roughness of between 0 and 150 mL/min, more preferably between 30 and 50 mL/min, besides a high compaction, with pores in the structure with dimensions below 100 nm.

The layer of the double layered cellulosic matrix for printing and electronic circuit integration (second layer) is constituted by in % w/w, 30% of cellulosic fibers, 50% of at least an inorganic pigment and 20% of cellulose micro and nanofibrils.

The double layered cellulosic matrix is produced by the steps involving the preparation of the first layer of the double layered cellulosic matrix, for incorporation of microfluidic systems, by refining pulp composed of cellulosic fibers and forming a sheet (matrix) from the resulting cellulosic pulp using sheet forming means; preparation of the second layer of the double layered cellulosic matrix for the integration of electronic components, by refining pulp composed of cellulosic fibers, mixing the resulting pulp with at least one inorganic pigment and cellulose micro and/or nanofibrils, and forming a sheet (matrix) from the resulting mixture using sheet forming means; depositing the previously prepared first layer on top of the second layer, and pressing the resulting cellulosic matrix with subsequent drying thereof.

In one embodiment of the invention, and according to the final application, the developed matrix can further incorporate a barrier of processed cellulosic fibers to the micro and / or nanoscale, i.e. cellulose micro and / or nanofibrils, and possibly chemically modified for having hydrophobic characteristics, between the two layers of the double layered cellulosic matrix. This allows, according to the application, the selection and formation of sealed zones in the double layered matrix allowing the retention of the fluid to be inserted for analysis in the microfluidic layer. The concept presented with this invention of a double layered cellulosic matrix for integrating microfluidic and electronic systems based on the same raw material, i.e. cellulosic material, is thus maintained. Incorporation of this barrier occurs upon the deposition of the first cellulosic layer on top of the second layer.

The final biodegradability of the sensors produced based on the developed cellulosic matrix is further ensured by the incorporation of compatible materials based inks (organic and or inorganic), non-polluting and recyclable.

The double layered cellulosic matrix is used in the production of detection systems, configuring a pioneering paper application. These may be applied on the health, pharmaceutical and food sectors, and additionally on safety and environmental monitoring, such as air/water quality regulation.

The double layer cellulosic matrix disclosed herein can thus be used in research and genetic analysis laboratories, which have frankly evolved from laboratory methodologies to Point of Care testing, benefiting from recent technological advances. Many forensic diagnostic or analysis laboratories and clinics require low-cost, simple systems with the ability to detect small samples quickly and reliably.

Examples are also the application in the packaging and distribution industries, where these devices could be adopted to inform the consumer about the quality of food (eg meat, beverages); and in the agricultural and veterinary sectors, for pathogen detection or unfavorable environmental conditions.

The matrix described herein is thus used in the production of intelligent detection systems, which include the microfluidic component / or sensors and the interface electronics required for communication, for medical, pharmaceutical, food, safety, agricultural, veterinary, environmental and packaging and distribution applications, among others.

### BRIEF DESCRIPTION OF THE DRAWINGS

Figure 1. Schematic representation of the flexible, double layered cellulose-based matrix, for simultaneous integration of electronics and microfluidics, described herein.
Figure 2. Characterization of cellulosic matrices for incorporation of microfluidic systems (first layer of the double layered cellulosic matrix) concerning average values of degree of refining, thickness, Bendtsen roughness and Bendtsen permeability.
Figure 3. SEM images with a 100x magnification of the 0R, 5R and 15R matrices.
Figure 4. SEM-EDS image of the 0R, 5R and 15R matrices composition.
Figure 5. Formulations used for the production of cellulosic matrices for incorporation of electronic/ electrochemical components (second layer of the double layered cellulosic matrix).
Figure 6. Average values for thickness, Bendtsen roughness and permeability for the developed double layered cellulosic matrices.
Figure 7. SEM images with 100x and 500x magnification of the first and second layers of the 15R_DCt4 double layered cellulosic matrix.
Figure 8. Resistances of the 15R_DCt4 double layered cellulosic matrix and of a commercial printed paper, identified as Office, with PEDOT: PSS printed layers.
Figure 9. Microfluidic channels in a) Office paper and b) in the first layer of the 15R-DCt4 double layered cellulosic matrix.
Figure 10. Sides of the 15R_DCt4 double layered cellulosic matrix, demonstrating how microfluidic channels are diffused through the matrix thickness until they reach the cellulosic layer for electronic / electrochromic printing (second layer of the double layered cellulosic matrix).
Figure 11. Architecture scheme of the printed transistors.
Figure 12. Average values for thickness, Bendtsen thickness and roughness: comparison between the 15R_DCt4 and the scaled-up 15R_DCt4_FD double layered cellulosic matrices.
Figure 13. Side of the second layer of the double layered cellulosic matrix with a carbon interdigital electrode sensor and a printed PEDOT: PSS sensitive layer and with microfluidic wells/channels diffused through the thickness of the double layered cellulosic matrix.

### DETAILED DESCRIPTION OF THE INVENTION

Presented at this invention are the technical requirements for cellulosic matrices necessary for the simultaneous implementation of electronic components and microfluidic systems, which allow the directed transport of fluids required for microfluidic applications, considering fluid transport velocity and the pH changes of these fluids after their passing through the cellulosic matrices, and the implementation of active (field effect transistors) and passive (resistors, conductors and capacitors) electronic components for printed electronics applications.

Thus we have the properties of thickness, porosity, surface roughness/smoothness, fiber purity (content in additives), surface area of the matrix, and air and liquid permeability. Porosity is a critical parameter to control in microfluidic applications: a high density (low porosity) can make it difficult from the channel formation to the fluid displacement itself, but a high porosity can also be a drawback due to uncontrolled diffusion of hydrophobization materials. Another important feature is the chemical stability so as not to interfere with the detection process, for example by changing the pH of a solution to be tested. Furthermore, and from the point of view of the printing of electronic and electrochemical components, attention should be focused on the plane and highly compact cellulosic layer, additionally to the roughness obtained for the matrix.

The thickness of the different cellulosic layers and matrices developed in this invention were measured with an L&W micrometer, using the method described in ISO Standard 534. Bendtsen roughness and permeability values were measured using the Bendtsen method, ISO standards 5636-3:2013 and ISO 8791-2 respectively, and using a L&W Bendtsen Tester equipment.

### Example 1

### a) Development of a flexible, isotropic, double layered, cellulose-based fibrous matrix for simultaneous integration of electronics and microfluidic

One of the most commonly used industrial processes for cellulosic pulp production is the Kraft process, or sulfate process, where wood chips are treated with a cooking bleach (white bleach), which is essentially sodium hydroxide (NaOH)and sodium sulfide (Na₂S).

For this example of an embodiment of this invention, cellulosic matrices for incorporating microfluidic systems onto its surface were produced using bleached *Eucalyptus globulus* Kraft cellulosic pulp with 3 distinct levels of refining (0; 500; 1500; 1800 rotations in a PFI refiner), identified with the designations 0R, 5R, 15R, 18R.

The refining level of the pulp suspensions was determined by the Schopper-Riegler method, following the standard ISO 5267-1:1999.

For each refining degree, round sheets (matrices) of isotropic structure (randomly distributed fibers) were manufactured in static sheet formers. After forming the matrices, they were placed on stainless steel plates and subjected to a press drying process and left to dry in a conditioned room.

The characterization of these matrices is shown in Figure 2, regarding thickness, Bendtsen roughness and Bendtsen permeability values.

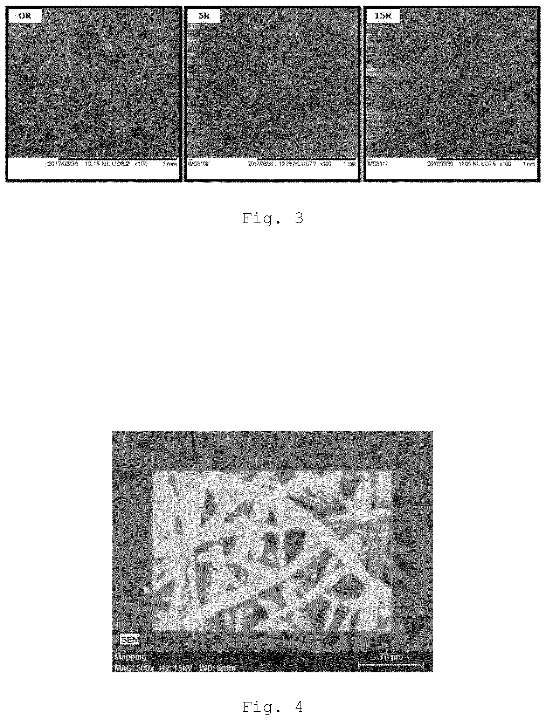

The purity of these matrices was examined by Scanning Electron Microscopy (SEM) analysis of the smoothest side at a 100x magnification. Figure 3 presents the images obtained. Complementary Dispersive Energy Spectroscopy (EDS) analysis confirmed that these matrices are composed only of cellulosic fibers, as only carbon and oxygen were found as shown in Figure 4. These data demonstrate the purity of the samples, also of high relevance for microfluidic applications.

Among the developed matrices, the 15R matrix (1500 PFI rotations refined bleached pulp) was selected as reference for the first layer, for microfluidic channels integration, of the new flexible, double layered cellulose-based matrix for simultaneous integration of electronic and microfluidic presented in this invention. The production process of this first layer is the same as that previously mentioned for the production of the matrix 15R, but interrupting the cycle after the formation of the sheets, where they are removed from the sheet former and set aside for later finishing with the second layer.

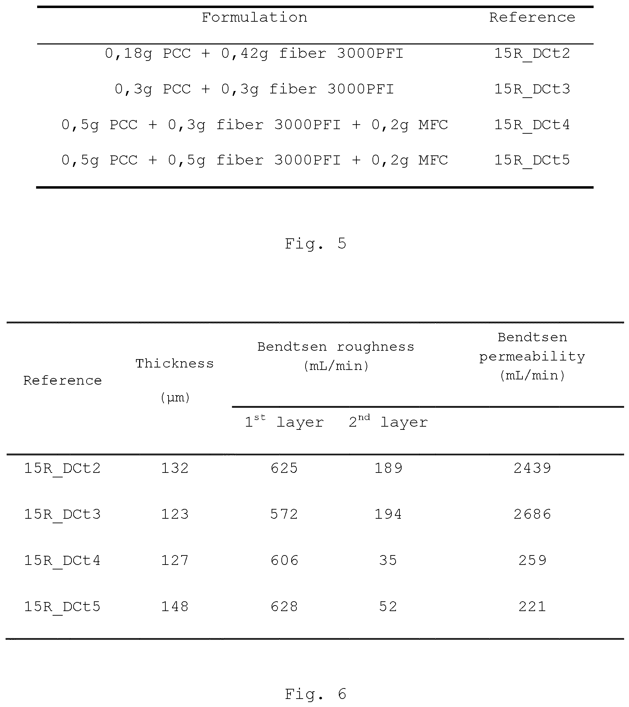

The second layer of the flexible, double layered cellulose-based matrix for simultaneous electronics and microfluidic integration will need to be able to guarantee functional levels of smoothness/roughness and of compactness when applied over the porous matrices for microfluidics, to allow deposition of the electrical and electrochemical components, as well as of the necessary conductive and resistive lines. Four formulations were tested, shown in Figure 5.

In the production of this second matrix it were used bleached *Eucalyptus globulus* Kraft cellulosic pulp refined at 3000 PFI rotations, as inorganic pigment precipitated calcium carbonate (PCC) with an average particle size of 2.8 pm, and microfibrillated cellulose (MFC). Precipitated calcium carbonate is a common additive used at industrial pulp and paper production processes.

In the production of this second matrix, the components of each formulation are premixed prior to adding the resulting mixture to the sheet former. As described for the production of the first layer, the process was also interrupted after the matrix formation step. After formation of the second layer, the previously prepared first layer was applied on top of it and subjected to a pressing step for 5 minutes with subsequent drying in a conditioned environment room (23 °C, 50% relative humidity).

The four new matrices were also characterized and the average values obtained depicted in Figure 6.

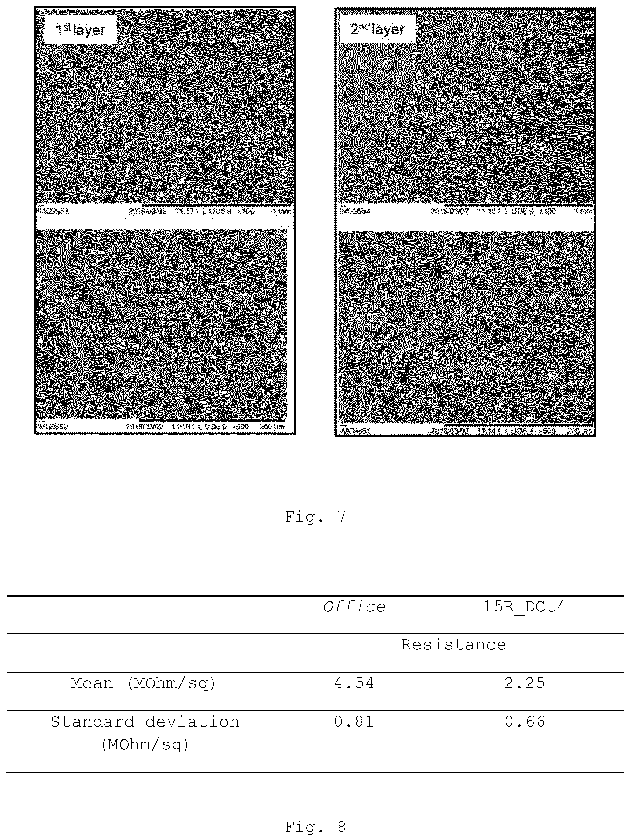

Subsequently, the double layered matrix with the reference 15R_DCt4 was selected for microfluidics and electronics components application tests. The appearance of the two layers was further verified by Scanning Electron Spectroscopy (Figure 7), and it can be seen that the second layer has a less porous structure as compared to the first layer composed solely of cellulose fibers, as desired for the applications concerned.

### b) Validation tests of the flexible, double layered cellulose-base matrix for simultaneous integration of electronics and microfluidics

The double layered cellulose-based matrix was tested concerning microfluidic channels formation and deposition of electronic devices, necessary for its use in detection systems at the most different sectors such as health, food, and environment, among others.

Xerox Corporation's wax-based solid ink printing technology was used to create lines at the 15R_DCt4 double layered cellulosic matrix, which will later be diffused through the thickness of the double layered matrix to create hydrophobic barriers capable of delimiting hydrophilic channels, as well as test and sample deposition zones.

Active layers of the conductive polymer PEDOT:PSS - Poly (3,4-ethylenedioxythiophene)-poly(styrenesulfonate) were applied by inkjet printing to the 15R_DCt4 double layered cellulosic matrix, and also to a commercial printing paper, referred to as Office. To infer about the printing quality of the layers, the electrical resistance of the PEDOT:PSS printed on the selected matrix and on the chosen paper sheet was measured using the Van der Pauw four-point geometry technique^{[26]}. The results are shown in Figure 8. The formation of a conductive printed film is possible with the Office paper and with the 15R-DCT4 matrix. In the case of the latter, the electrical resistance of the printed circuits on the sheet is half when compared to that obtained with the Office paper, which suggests a better quality of the printed PEDOT:PSS film, demonstrating as practicable one of the possible applications of the developed matrices, namely in the production of electrochemical biosensor platforms, since the PEDOT:PSS polymer is widely used in biological-electronic interfaces^{[27]}.

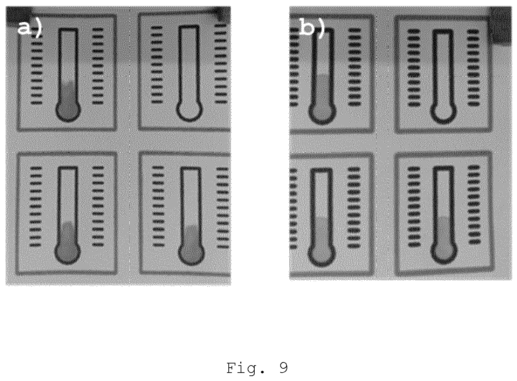

A capillary test was performed by printing a selected microfluidic channel pattern and adding 5µL of a dye in ultrapure water on an Office paper (a) and on the selected double layered matrix 15R-DCt4 (b) as shown in Figure 9. The first layer of the 15-DCt4 matrix, i.e. for microfluidic application, gives better results than with the Office paper, particularly as regards to the speed and distance achieved for a 5µL liquid volume.

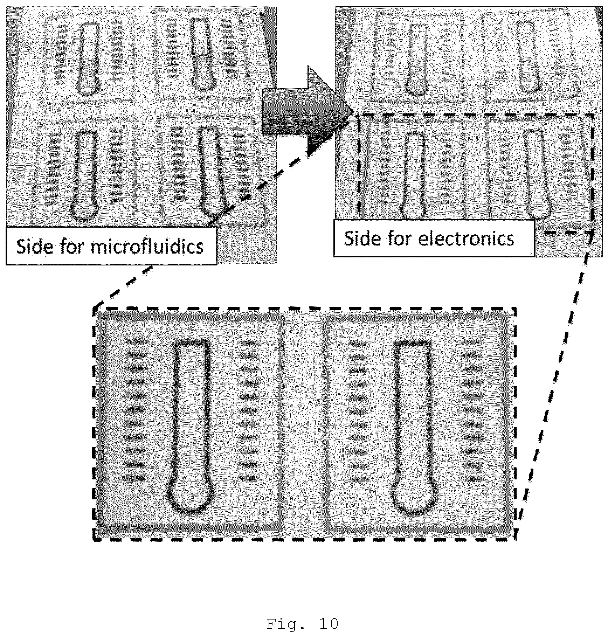

As mentioned above, the microfluidic channels printed on the porous layer, i.e., the first layer of the double layered cellulosic matrix for microfluidic application, are diffused through the thickness of the 15R_DCt4 double layered cellulosic matrix until they reach the second layer of the matrix, formulated for printing electronic components. The liquid added to the cellulosic layer for microfluidic is also directed by the microfluidic channels formed through the double layered matrix to the second matrix layer. This is shown in Figure 10.

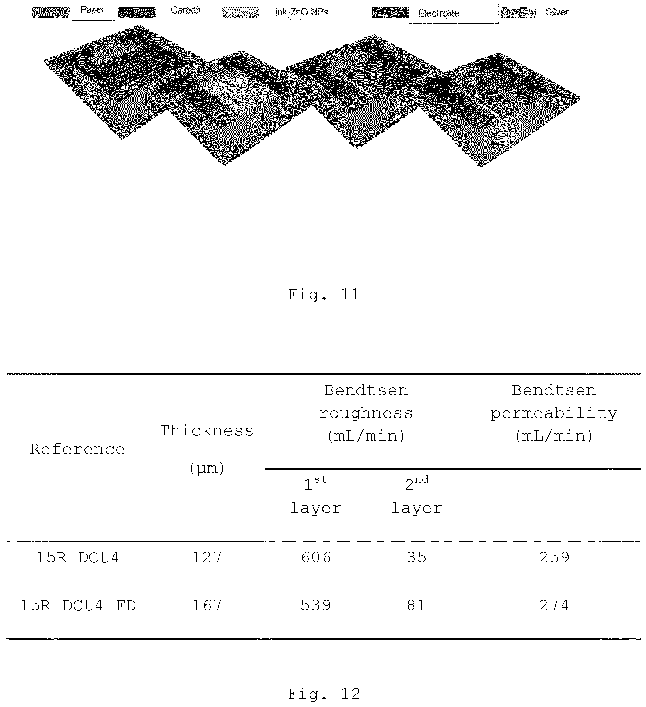

Transistors were also printed on the second layer of the developed double layered matrix, 15R_DCt4. The transistors have an interdigital configuration, using source electrodes, carbon gate and drain and a ZnO semiconductor layer, all layers being screen printed. The device is then completed by an electrolytic membrane that joins the semiconductor to the gate electrode. The transistor architecture scheme is shown in Figure 11.

The transistors were characterized in a probe station where voltage values between -0.5 and 2.5 V were applied to the gate electrode, being monitored the current between the source and drain, thus obtaining the transfer curves (or of input). These present the correct and expected behavior in terms of drain current and on/off ratio.

### Example 2

### a) Scale-up of the double layered flexible cellulose-based matrix for simultaneous integration of electronics and microfluidics

A 10-fold scale-up of the total area of the developed double-layered cellulosic matrix was performed, with an anisotropic fibrous matrix with preferential fiber orientation being produced.

The pilot unit includes a dynamic sheet former that allows the production of cellulosic matrices from a cellulosic pulp suspension. The structures can be produced by adjusting the fiber orientation (machine direction or transverse direction) and matrices consolidation variations by pressing. The scale-up of the double layer matrix was thus carried out, and the corresponding reference 15R_DCt4_FD was adopted.

At the scale-up of the matrix it was created a first layer of weight 60 g/m² (100% bleached *Eucalyptus globulus* cellulose fiber refined at 1500 PFI rotations) and directly on this layer it was deposited the second layer with a weight of 50 g/m² (30% w/w bleached *Eucalyptus globulus* cellulosic fiber refined at 3000 PFI rotations + 50% w/w precipitated calcium carbonate + 20% w/w microfibrillated cellulose). After the formation of the structure, the same was subjected to a press cycle at 2, 4 and 3 x 5 bar with subsequent drying at 60°C. The results of the characterization of the produced matrix are presented in Figure 12.

The scale-up matrix 15R_DCt4_FD has a roughness (in the second layer) increase of 45 mL/min, with no negative impact on transistors printing. The matrix conditions required for the simultaneous implementation of microfluidic and electronic components were thus replicated.

In order to compare the performance of the matrix produced, in terms of surface resistance and printing quality, a linting test was performed using an IGT AIC2-5T2000 apparatus.

This test simulates an offset-type print and measures the ability of a paper to resist material tearing from its surface during the printing process due to the tension created by the ink. For the test execution, an ink film of known thickness (8 pm) is applied to a rubber roller (hardness 65 shore A). The ink rubber roller is then pressed against the test sample (650 N force) and the ink is transferred under acceleration (1 m/s terminal speed). When the force exerted by the ink is greater than the cohesive force of the paper surface, the material is torn away damaging the surface.

It has been observed that the final surface quality after ink transfer is clearly higher in the 15R_DCt4_FD matrix over a commercial Office printing and writing paper, while still having the advantage of allowing microfluidic systems to be applied to the first layer of the matrix.

### a) Description of the way of operating the double layered cellulose-based flexible matrix for simultaneous integration of electronics and microfluidics

The following illustrates one of the possible ways of operating the developed matrix, namely in pH detection. Interdigital carbon electrodes and a PEDOT:PSS sensitive layer were used. The production process of the sensors begins with printing patterns of circular wax channels / wells on the first layer of the cellulosic matrix, i.e. developed for microfluidic application. The matrix is heated to 140 ° C to diffuse the wax wells / channels along its double layer thickness. Subsequently, the sensitive components are printed on the second layer using an inkjet printer.

The sensor consisting of carbon interdigital electrodes and of a PEDOT:PSS sensitive layer works by changing the resistivity of the polymer when subjected to different pH levels. In this sense, 3 to 10 pH buffer solutions were used and injected into the microfluidic channels to reach the sensitive layer. The sensors were continuously monitored under chronoamperometry, starting the current measurement with approximately 60 seconds in the dry state, the addition of the pH solution and another 240 seconds for stabilization.

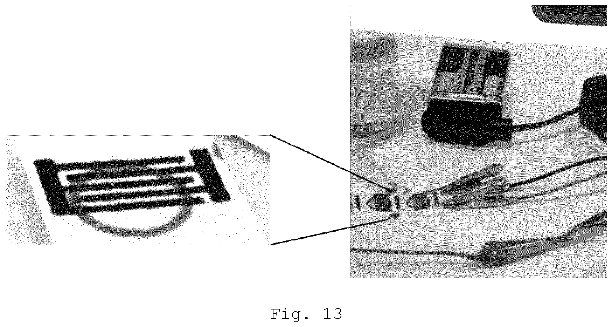

Figure 13 depicts the flexible double layered cellulose-based matrix incorporating electronics and microfluidic components in a test carried out to measure the pH of a solution.

## Claims

1. A cellulosic matrix, flexible, for simultaneous integration of electronics, electrochemistry and microfluidics, comprising a first layer consisting of cellulosic fibers and having a Bendtsen permeability of 1500 to 3000 mL/min, preferably of 2600 to 2700 mL/min, and a second layer comprising 30% (w/w) of cellulosic fibers, 50% (w/w) of at least one inorganic pigment and 20% (w/w) of cellulose micro and/or nanofibrils and having a Bendtsen roughness of 0 to 150 mL/min, preferably of 30 to 50 mL/min, and pores smaller than 100 nm.

2. The matrix according to the preceding claim, comprising a barrier of cellulose micro and/or nanofibrils between the first and the second layers.

3. A process for manufacturing the matrix described in the preceding claims, comprising the following steps:
a) First layer preparation:
- refining cellulosic fibers pulp;
- forming a matrix from the resulting mixture;
b) Second layer preparation:
- refining cellulosic fibers pulp;
- mixing the resulting pulp with at least one inorganic pigment and cellulose micro and/or nanofibrils;
- forming a matrix from the resulting mixture;
c) Deposition of the first layer on top of the second layer;
d) Pressing the resulting matrix with subsequent drying thereof.

4. The process according to claim 3, comprising a step of incorporating a cellulose micro and/or nanofibrils barrier between the two matrix layers upon the deposition of the first layer on top of the second layer.

5. The use of the matrix described in claims 1 and 2, for the production of intelligent detection systems, which include the microfluidic component/or sensors and the interface electronics required for communication, for medical, pharmaceutical, food, security, agricultural, veterinary, environmental and packaging and distribution application sectors.

## Patentansprüche

1. Flexible Cellulosematrix für die gleichzeitige Integration von Elektronik, Elektrochemie und Mikrofluidik, umfassend eine erste Schicht, die aus Cellulosefasern besteht und eine Bendtsen-Permeabilität von 1500 bis 3000 mL/min, vorzugsweise 2600 bis 2700 mL/min, aufweist, und eine zweite Schicht, die 30 % (Gew./Gew.) Cellulosefasern, 50 % (Gew./Gew.) mindestens ein anorganisches Pigment und 20 % (Gew./Gew.) Cellulose-Mikro- und/oder -Nanofibrillen umfasst und eine Bendtsen-Rauigkeit von 0 bis 150 mL/min, vorzugsweise 30 bis 50 mL/min, und Poren kleiner als 100 nm aufweist.

2. Matrix nach dem vorhergehenden Anspruch, umfassend eine Barriere aus Cellulose-Mikro- und/oder -Nanofibrillen zwischen der ersten und der zweiten Schicht.

3. Verfahren zur Herstellung der in den vorhergehenden Ansprüchen beschriebenen Matrix, umfassend die folgenden Schritte:
a) Vorbereitung der ersten Schicht:
- Veredelung von Cellulosefasern Zellstoff;
- Bilden einer Matrix aus der resultierenden Mischung;
b) Vorbereitung der zweiten Schicht:
- Veredelung von Cellulosefasern Zellstoff;
- Mischen des entstandenen Zellstoffs mit mindestens einem anorganischen Pigment und Cellulose Mikro- und/oder Nanofibrillen;
- Bildung einer Matrix aus der resultierenden Mischung;
c) Abscheidung der ersten Schicht auf der zweiten Schicht;
d) Pressen der entstandenen Matrix mit anschließender Trocknung.

4. Verfahren nach Anspruch 3, umfassend einen Schritt des Einbaus einer Cellulose-Mikro- und/oder Nanofibrillen-Barriere zwischen den beiden Matrixschichten bei der Abscheidung der ersten Schicht auf der zweiten Schicht.

5. Die Verwendung der in den Ansprüchen 1 und 2 beschriebenen Matrix zur Herstellung intelligenter Detektionssysteme einschliesslich der mikrofluidischen Komponente/oder Sensoren und der Schnittstellenelektronik, die für die Kommunikation in den Bereichen Medizin, Pharma, Lebensmittel, Sicherheit, Landwirtschaft, Veterinärwesen und Umwelt sowie in erforderlich sind den Anwendungsbereichen Verpackung und Vertrieb.

## Revendications

1. Matrice cellulosique, flexible, pour l'intégration simultanée de l'électronique, de l'électrochimie et de la microfluidique, comprenant une première couche constituée de fibres cellulosiques et ayant une perméabilité de Bendtsen de 1500 à 3000 mL/min, de préférence de 2600 à 2700 mL/min, et une deuxième couche comprenant 30 % (p/p) de fibres cellulosiques, 50 % (p/p) d'au moins un pigment inorganique et 20 % (p/p) de micro et/ou nanofibrilles de cellulose et ayant une rugosité Bendtsen de 0 à 150 ml/min, de préférence de 30 à 50 ml/min, et des pores inférieurs à 100 nm.

2. La matrice selon la revendication précédente, comprenant une barrière de micro et/ou nanofibrilles de cellulose entre la première et la deuxième couche.

3. Procédé de fabrication de la matrice décrite dans les revendications précédentes, comprenant les étapes suivantes :
a) Préparation de la première couche:
- raffinage de la pâte de fibres cellulosiques;
- former une matrice à partir du mélange résultant;
b) Préparation de la deuxième couche:
- raffinage de la pâte de fibres cellulosiques;
- mélanger la pâte obtenue avec au moins un pigment inorganique et des micro et/ou nanofibrilles de cellulose;
- former une matrice à partir du mélange obtenu;
c) Dépôt de la première couche par-dessus la deuxième couche;
d) Pressage de la matrice obtenue avec séchage ultérieur de celle-ci.

4. Procédé selon la revendication 3, comprenant une étape d'incorporation d'une barrière de micro et/ou nanofibrilles de cellulose entre les deux couches de la matrice lors du dépôt de la première couche sur la deuxième couche.

5. L'utilisation de la matrice décrite dans les revendications 1 et 2, pour la production de systèmes de détection intelligents, qui comprennent le composant microfluidique et/ou les capteurs et l'électronique d'interface nécessaire à la communication, pour les secteurs d'application médicaux, pharmaceutiques, alimentaires, de sécurité, agricoles, vétérinaires, environnementaux et de l'emballage et de la distribution.
